(19) Europäisches Patentamt
European Patent Office
Office européen des brevets

(11) **EP 2 607 910 B1**

(12) # EUROPEAN PATENT SPECIFICATION

(45) Date of publication and mention
of the grant of the patent:
**23.03.2016 Bulletin 2016/12**

(51) Int Cl.:
***G01R 31/36*** (2006.01)

(21) Application number: **12162201.3**

(22) Date of filing: **29.03.2012**

(54) **A device and method for estimating life of a secondary battery**

Vorrichtung und Verfahren zum Abschätzen der Lebensdauer einer Sekundärbatterie

Dispositif et procédé pour estimer la durée de vie d'une batterie secondaire

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **23.12.2011 US 201161579890 P**

(43) Date of publication of application:
**26.06.2013 Bulletin 2013/26**

(73) Proprietor: **Samsung SDI Co., Ltd.
Yongin-si, Gyeonggi-do (KR)**

(72) Inventors:
• **Suh, Seung Bum**
**Gyeonggi-do (KR)**
• **Lee, Jang-Woo**
**Gyeonggi-do (KR)**
• **Kim, Jake**
**Gyeonggi-do (KR)**
• **Kim, Jongman**
**Gyeonggi-do (KR)**
• **Lee, Su Dong**
**Gyeonggi-do (KR)**
• **Yang, Seung Ho**
**Gyeonggi-do (KR)**
• **Cheong, Kyeong-Beom**
**Gyeonggi-do (KR)**
• **Kim, Wonseock**
**Gyeonggi-do (KR)**
• **Jung, InHo**
**Gyeonggi-do (KR)**
• **Song, Joo Han**
**Gyeonggi-do (KR)**
• **Chai, Heekwan**
**Gyeonggi-do (KR)**
• **Shin, Jeongsoon**
**Gyeonggi-do (KR)**
• **Ko, Younghwa**
**Gyeonggi-do (KR)**
• **Joung, Boung Gun**
**Gyeonggi-do (KR)**
• **Baeg, Kwangki**
**Gyeonggi-do (KR)**
• **Park, Cheol Ho**
**Gyeonggi-do (KR)**
• **Kim, YongSic**
**Gyeonggi-do (KR)**
• **Baek, Hoyul**
**Gyeonggi-do (KR)**

(74) Representative: **Walaski, Jan Filip et al
Venner Shipley LLP
200 Aldersgate
London EC1A 4HD (GB)**

(56) References cited:
**US-A1- 2011 060 538**

• YINJIAO XING ET AL: "Prognostics and health monitoring for lithium-ion battery", INTELLIGENCE AND SECURITY INFORMATICS (ISI), 2011 IEEE INTERNATIONAL CONFERENCE ON, IEEE, 10 July 2011 (2011-07-10), pages 242-247, XP032018628, DOI: 10.1109/ISI.2011.5984090 ISBN: 978-1-4577-0082-8
• SPOTNITZ R: "Simulation of capacity fade in lithium-ion batteries", JOURNAL OF POWER SOURCES, ELSEVIER SA, CH, vol. 113, no. 1, 1 January 2003 (2003-01-01), pages 72-80, XP004399047, ISSN: 0378-7753, DOI: 10.1016/S0378-7753(02)00490-1

**Description**

The present invention provides a device and method for estimating battery life of a secondary battery, particularly but not exclusively an accelerated life estimation device for long life prediction of a secondary battery.

In order to ensure a life of a secondary battery during development of the secondary battery, charge and discharge operations are repeatedly performed under conditions and time periods, which are similar to those for a case where the secondary battery is actually used, and a long life is estimated of the secondary battery by measuring a cycle life (residual capacity ratio) whenever measurement is made.

A time required for evaluating the cycle life of the secondary battery is approximately 50% or greater of the entire time required for development of the secondary battery. Thus, the evaluating of the cycle life of the secondary battery is a critical factor in reducing the time required for development of the secondary battery.

In particular, in view of characteristics of products of IT fields, which are developed in a very short time interval, compared to products of other fields, it is quite demanding to reduce the time for cycle life evaluation.

D1 (US2011/060538 A1) discloses methods and apparatus wherein state-of-health in a battery is estimated by comparing the terminal voltage with a calculated terminal voltage.

D2 (Intelligence and Security Informatics (ISI) pages 242-247 July 2007) discloses battery health monitoring methods which exploit battery failure mechanism in conjunction with data-driven techniques.

D3 (Journal of Power Sources, volume 113, pages 72-80 January 2003) discloses various acceleration factors for accelerated life testing of a chemical battery such as temperature, discharge rate, ratio of charge/discharge rates, and depth of discharge.

According to an aspect of the present invention, there is provided a device for estimating battery life of a secondary battery according to claim 1.

According to a further aspect of the present invention, there is provided a method for estimating battery life of a secondary battery according to claim 14.

Optional features are set out in the dependent claims.

The data processing unit may comprise a parameter extraction unit for extracting parameters from the first and second battery life test data, an acceleration factor calculation unit for calculating the acceleration factor from the extracted parameters and a normal life prediction unit for estimating the life of the battery.

The first battery life test data may include cycle and capacity values obtained by charging and/or discharging a first battery with a first current, and the second battery life test data include cycle and capacity values obtained by charging and/or discharging a second battery with a second current greater than the first current.

The first battery life test data may include cycle and capacity values obtained by leaving a first battery at a first temperature for a first predetermined period, and the second battery life test data may include cycle and capacity values obtained by leaving a second battery at a second temperature for a second predetermined period, the second temperature being higher or lower than the first temperature, or the second temperature being equal to the first temperature, and the second predetermined period being shorter or longer than the first predetermined period, or the second predetermined period being equal to the first predetermined period.

The data processing unit may be arranged to calculate the acceleration factor using a semi-empirical life model of the battery or a statistical life analysis model of the battery.

The data processing unit may be arranged to calculate the acceleration factor using the equation:

$$AF = \frac{t(\mathrm{normal})}{t(\mathrm{accelerated})} = \frac{C-rate(a)}{C-rate(n)} \times \frac{Swing(n)}{Swing(a)} \times \left( \frac{A_a\big(C-rate(a), Swing(a)\big)}{A_n\big(C-rate(n), Swing(n)\big)} \right)^2$$

where t(normal) is a normal life test time for providing the first battery life test data, t(accelerated) is an accelerated life test time for providing the second battery life test data; C-rate (n) is a charge and/or discharge current used in a normal life test, C-rate (a) is a charge and/or discharge current used in an accelerated life test, Swing (n) is a charge and/or discharge cut-off voltage used in the normal life test, Swing (a) is a charge and/or discharge cut-off voltage used in the accelerated life test, $A_n$ is a slope parameter defining a slope of a graph of battery capacity against number of cycles at the normal life test time, and $A_a$ is a slope parameter defining a slope of a graph of battery capacity against number of cycles at the accelerated test time.

The data processing unit may be arranged to calculate the acceleration factor using the equation:

$$AF = k \times \frac{C-rate(a)}{C-rate(n)} \quad \text{or} \quad k \times (time\_ratio)$$

where C-rate (n) is a charge and/or discharge current used in a normal life test for providing the first battery life test data, C-rate (a) is a charge and/or discharge current used in an accelerated life test for providing the second battery life test data, time_ratio is a ratio of an initial 100 cycles to an evaluation time and k is a deteriorated acceleration factor which is calculated using the following equation:

$$k = \frac{\sum [b_n x_a y_a - a_n b_n x_a + b_n^2 x_n x_a]}{\sum [b_n x_a]^2}$$

where the subscript n denotes a normal life test condition, the subscript a denotes an accelerated life test condition, x denotes cycle numbers, y denotes a residual capacity ratio, $b_n$ denotes a slope between data of the battery capacity and cycle numbers at the normal lifetime test, and $a_n$ denotes the y-intercept.

The data processing unit may be arranged to calculate the estimated battery life by multiplying the acceleration factor AF by the second battery life test data.
The device may further comprise a storage device for storing one or more of the first and second battery life test data, the extracted parameters, the acceleration factor and the estimated life of the battery.

The device may further comprise a display device for displaying one or more of the first and second battery life test data, the extracted parameters, the acceleration factor and the estimated life of the battery.

The first and/or the second battery life test data may comprise one or more of residual capacity ratio, cycle numbers, charge and/or discharge currents and charge and/or discharge cut-off voltages.

The parameter extraction unit may be arranged to extract a slope parameter for a residual capacity ratio relative to cycles from the input first and second battery life test data.

The first battery life test data may include cycle and capacity values obtained by charging and/or discharging a first battery with a first voltage, and the second battery life test data may include cycle and capacity values obtained by charging and/or discharging a second battery with a second voltage, the second voltage being higher or lower than the first voltage, or the second voltage being equal to the first voltage.

As described above, according to an embodiment of the present invention, the accelerated life estimation device for long life prediction of a secondary battery and the method thereof can accurately estimate a normal life of the secondary battery under the evaluated accelerated conditions while reducing a life evaluation time of the secondary battery.

A prismatic secondary battery requires an evaluation time of approximately 150 days under normal conditions and approximately 40 days under accelerated conditions according to the present invention. In addition, a pouch type battery requires an evaluation time of approximately 90 days under normal conditions and approximately 30 days under accelerated conditions according to the present invention. In addition, a cylindrical battery requires an evaluation time of approximately 90 days under normal conditions and approximately 43 days under accelerated conditions according to the present invention. The above-stated evaluation time is provided only for illustration and may vary according to the material, manufacturing process and capacity of battery.

In addition, in one embodiment of the present invention, long life prediction of a secondary battery can be achieved within a short time, thereby ultimately shortening the entire development time of the secondary battery.

In one example, while the conventional secondary battery requires a long estimation time of approximately 50% the entire development time, the secondary battery according to the present invention requires a much shorter estimation time that of the conventional secondary battery, thereby reducing the development time of the secondary battery.

In addition, there is an error rate of approximately 5% or less or 100 cycles or less between a life (residual capacity ratio) of a secondary battery estimated by the accelerated life estimation method according to an embodiment of the present invention and a life (residual capacity ratio) of a secondary battery estimated by the normal life estimation method. Therefore, the long life estimation value estimated by the accelerated life estimation device according to an embodiment of the present invention and the method thereof has very high accuracy and reliability.

Embodiments of the invention will now be described by way of example with reference to the accompanying drawings, in which:

Fig. 1 is a conceptual diagram illustrating a flowchart of battery estimation using an accelerated life estimation method for long life predicting of a secondary battery according to an embodiment of the present invention;
Fig. 2 is a conceptual diagram illustrating an accelerated life estimation method for long life prediction of a secondary battery according to an embodiment of the present invention;
Figs. 3a to 3f are detailed conceptual diagrams illustrating an accelerated life estimation method for long life prediction of a secondary battery according to an embodiment of the present invention;
Fig. 4 is a block diagram of an accelerated life estimation device for long life prediction of a secondary battery according to an embodiment of the present invention;

Fig. 5 is a flowchart illustrating an accelerated life estimation method for long life prediction of a secondary battery according to an embodiment of the present invention;

Figs. 6a to 6e illustrate an example of an accelerated life estimation method for long life prediction of a secondary battery according to an embodiment of the present invention;

Figs. 7a and 7b illustrate a verification example of evaluation results of an accelerated life estimation method for long life prediction of a secondary battery according to an embodiment of the present invention;

Figs. 8a and 8b illustrate another verification example of evaluation results of an accelerated life estimation method for long life prediction of a secondary battery according to an embodiment of the present invention;

Figs. 9a, 9b and 9c are cross-sectional views illustrating examples of a prismatic battery, a pouch type battery and a cylindrical battery;

Fig. 10 is a graph illustrating error rates depending on the accelerated life estimation method for long life prediction of a secondary battery according to an embodiment of the present invention; and

Fig. 11 is a graph illustrating coherence between normal capacity and accelerated capacity.

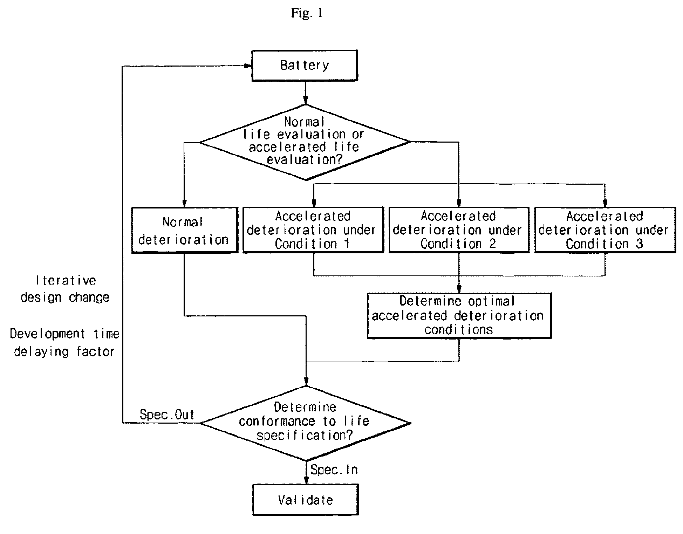

As shown in Fig.1, the secondary battery manufactured according to various and complex specification factors is subjected to life evaluation by a normal life estimation method or an accelerated life estimation method according to the present invention. In the normal life estimation method, a life (residual capacity ratio) of the secondary battery is evaluated while the secondary battery is allowed to deteriorate under normal conditions. In the accelerated life estimation method according to the present invention, a life (residual capacity ratio) of the secondary battery is evaluated while the secondary battery is allowed to deteriorate under accelerated conditions.

In the accelerated life estimation method, compared to in the normal life estimation method, charge and/or discharge currents, charge and/or discharge cut-off voltages, temperature and shelf time are adjusted, thereby reducing an accelerated life evaluation time compared to a normal evaluation time. In other words, an accelerated state is severer than a normal state. Accordingly, the secondary battery deteriorates fast, so that the life evaluation time of the secondary battery becomes shortened. Meanwhile, conditions for the accelerated life estimation method of the secondary battery may vary according to kinds of secondary battery, which is also applied to the normal life estimation method. The secondary battery is typically classified into a prismatic battery, a pouch type battery and a cylindrical battery. In addition, since even secondary batteries of the same type may have different materials and composition ratios, evaluation conditions optimized according to characteristics of secondary battery manufactured should be empirically determined.

In addition, if the cycle life of a secondary battery is predicted according to normal conditions and accelerated conditions according to the present invention, and it is determined that the predicted cycle life of the secondary battery lies in a life tolerance range (Spec In), secondary batteries to which the various and complex specification factors are applied can be manufactured. If it is determined that the predicted cycle life of the secondary battery lies out of a life tolerance range (Spec Out), the various and complex specification factors are varied to manufacture secondary batteries.

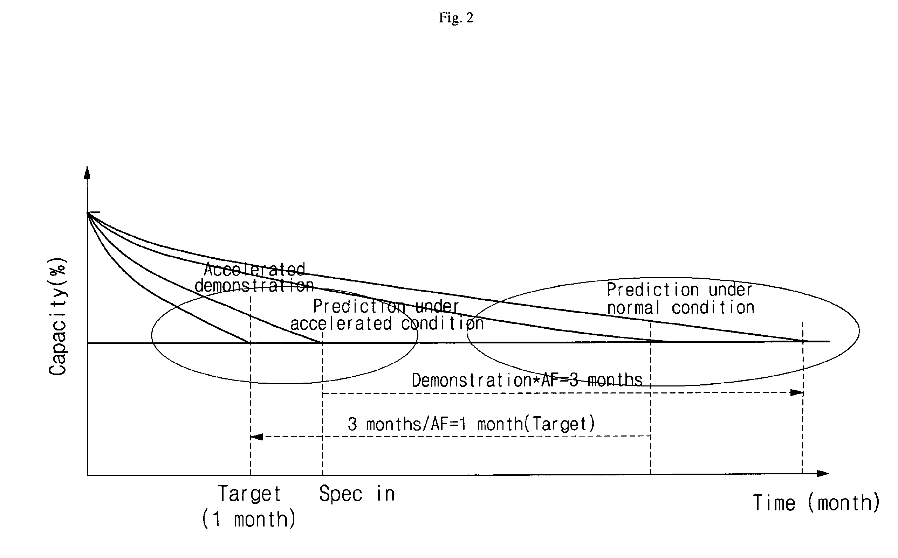

Fig. 2 is a conceptual diagram illustrating an accelerated life estimation method for long life prediction of a secondary battery according to an embodiment of the present invention, where the X axis indicates an evaluation time (month) of a secondary battery and the Y axis indicates a life (residual capacity ratio (%)) of the secondary battery. As shown in Fig. 2, in order to measures a life (residual capacity ratio) under normal conditions requested by a customer (e.g. a manufacturing company of an electronic product having a secondary battery mounted therein), an evaluation period of approximately 3 months may be required, which is, however, detrimental to an IT product having a very short cycle life. To overcome the shortcoming, the present invention provides an accelerated life estimation device for long life prediction of a secondary battery and a method thereof. For example, data of an accelerated life of approximately 1 months can be used in obtaining normal life data. Here, in order to obtain the normal life data from the accelerated life data, an acceleration factor (AF) is used, which will be described below in detail.

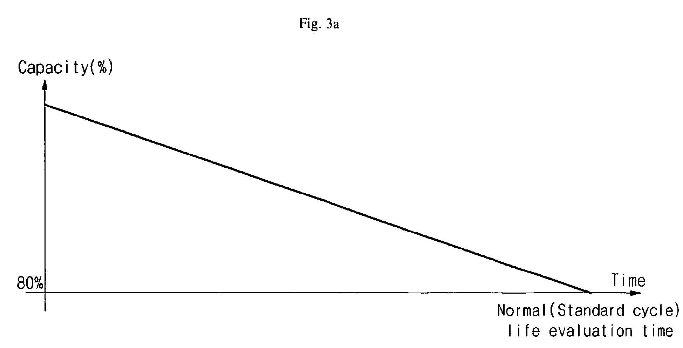

Figs. 3a to 3f are detailed conceptual diagrams illustrating an accelerated life estimation method for long life predicting of a secondary battery according to an embodiment of the present invention, in which the X axis indicates time and the Y axis indicates residual capacity ratio (%).

As shown in Fig. 3a, in order to determine whether a normal life of a secondary battery lies in a tolerance range (Spec In) or out of a tolerance range (Spec Out), it is necessary to measure an actual life (residual capacity ratio) of a secondary battery relative to the number of charging and/or discharging cycles. In order to measure the actual life (residual capacity ratio) of a secondary battery relative to the number of charging and/or discharging cycles, a considerable time is required. Here, the tolerance range is based on the time taken when the capacity of the secondary battery is reduced to approximately 80%.

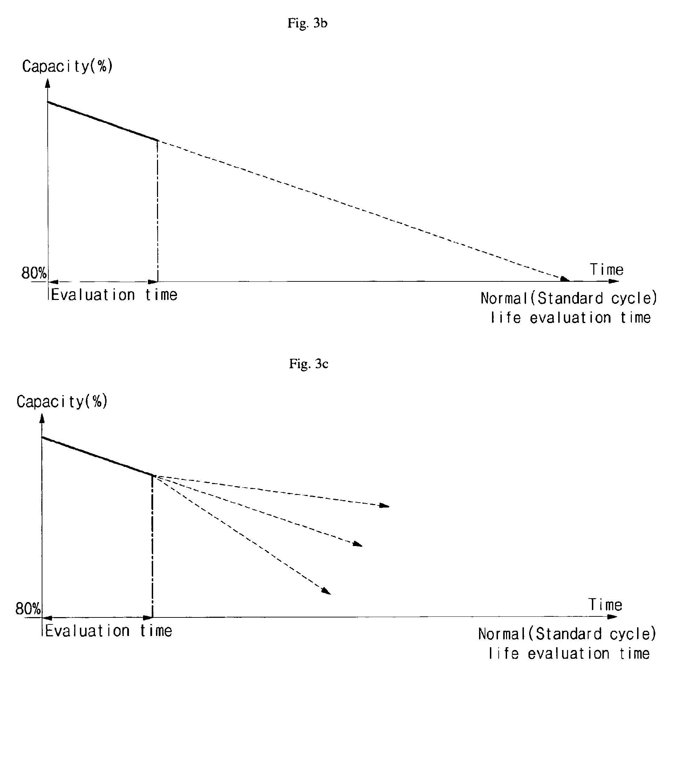

As shown in Fig. 3b, in order to reduce a life evaluation time of a secondary battery, actual evaluation is conducted for a relatively short time, and a residual life time can be predicted through data obtained for the short time.

However, as shown in Fig. 3c, it is not accurately predict in which direction deterioration of the secondary battery occurs.

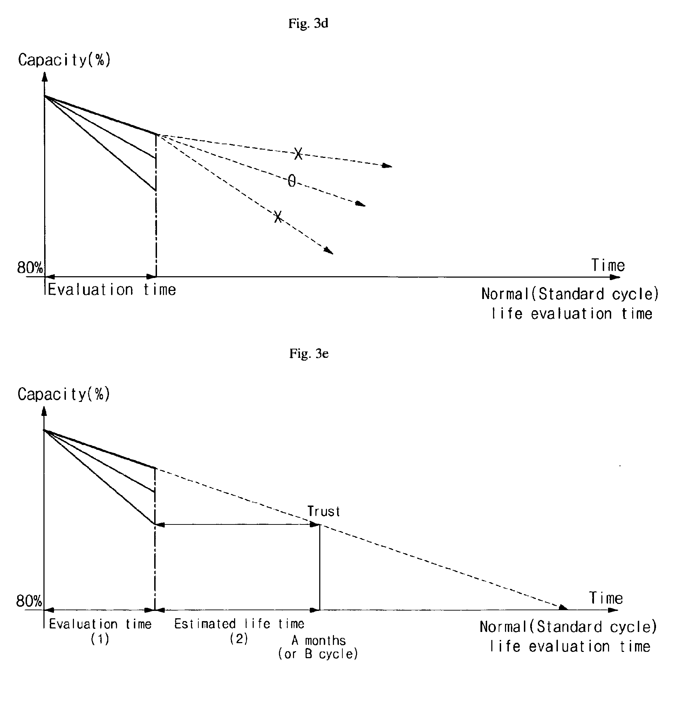

Thus, as shown in Fig. 3d, data of the life (residual capacity ratio) of a secondary battery may be measured under normal and accelerated conditions, and an equation for life prediction under normal conditions may be derived from the data.

As shown in Fig. 3e, an evaluation time (1) under accelerated conditions can be extended to an estimated life time (2) under normal conditions. That is to say, the relatively long estimated life time (2) can be obtained using the relatively short evaluation time (1). Here, the time may be number of months or cycles.

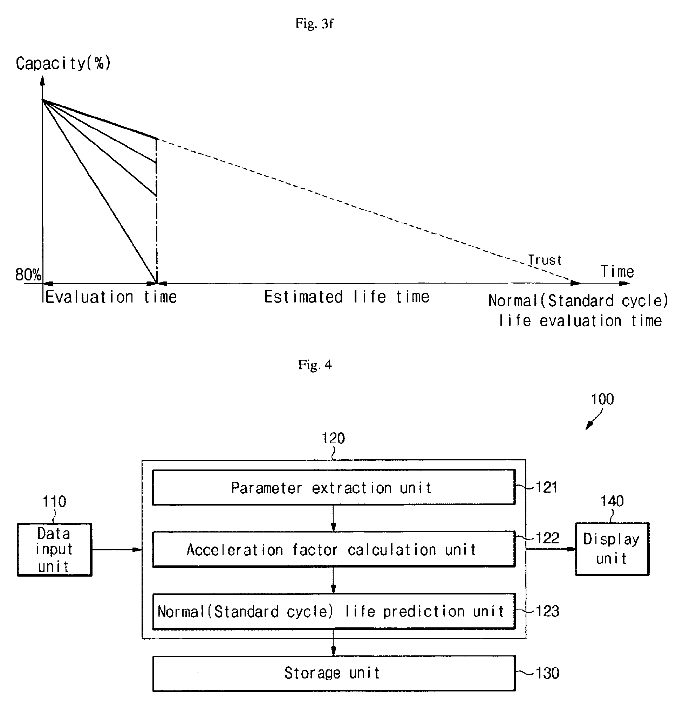

As shown in Fig. 3f, if the life of the secondary battery is evaluated under severer accelerated conditions, a reliable period for an estimated life time can be further extended.

Fig. 4 is a block diagram of an accelerated life estimation device for long life predicting of a secondary battery according to an embodiment of the present invention.

As shown in Fig. 4, an accelerated life estimation device 100 according to an embodiment of the invention includes a data input unit 110, a data processing unit 120, a storage unit 130 and a display unit 140. In practice, the accelerated life estimation device 100 may be implemented by a personal computer, a server computer and equivalents thereof, but aspects of the present invention are not limited thereto.

Normal life test data (first battery life test data) conducted for a given time, such as residual capacity ratio, cycle numbers, charge and/or discharge currents, charge and/or discharge cut-off voltage, or the like, may be input to the data input unit 110. In addition, accelerated life test data (second battery life test data) conducted for a given time, such as residual capacity ratio, cycle numbers, charge and/or discharge currents, charge and/or discharge cut-off voltages, or the like, may also be input to the data input unit 110. The data may be automatically input from a test, measurement or evaluation device, or may be manually input using a keyboard or mouse.

In addition, the data may be obtained by a cycle method or an interval method, which will be described below in more detail.

The data processing unit 120 includes a parameter extraction unit 121, an acceleration factor calculation unit 122 and a normal (standard cycle) life prediction unit 123. The data processing unit 120 may be implemented by a program run on a computer, software and equivalents thereof, but aspects of the present invention are not limited thereto.

The parameter extraction unit 121 may extract a slope parameter A for a residual capacity ratio relative to cycles from the input normal life test data and the data of accelerated life test. In addition, the parameter extraction unit 121 may simply extract the cycle numbers and residual capacity ratio.

In addition, the acceleration factor calculation unit 122 calculates the acceleration factor (AF) using the extracted parameter and an equation associated with a semi-empirical life model or an equation associated with a statistical life analysis model, which will be described below.

Finally, the normal (standard cycle) life prediction unit 123 estimates a normal (standard cycle) life of the secondary battery from a residual capacity ratio relative to a time (number of months or cycles).

For example, a normal (standard cycle) life, which is the same as that obtained from 3 month data, is estimated using one month data.

Meanwhile, the storage unit 130 stores various kinds of data of the data input unit 110 and the data processing unit 120. That is to say, the storage unit 130 stores the test data input from the data input unit 110, the parameters, the acceleration factor (AF) and the estimated normal (standard cycle) life data. The storage unit 130 may be generally a hard disk, a flash memory, a CD-ROM, and equivalents thereof, but aspects of the present invention are not limited thereto.

In addition, the display unit 140 displays various kinds of data of the data input unit 110 and the data processing unit 120. That is to say, the display unit 140 displays not only the test data input to the data input unit 110 but also the parameter, the acceleration factor (AF) and the estimated normal (standard cycle) life data. The display unit 140 may be generally a LCD monitor and equivalents thereof, but aspects of the present invention are not limited thereto.

The operation of the accelerated life estimation device will be described in more detail through the accelerated life estimation method that follows.

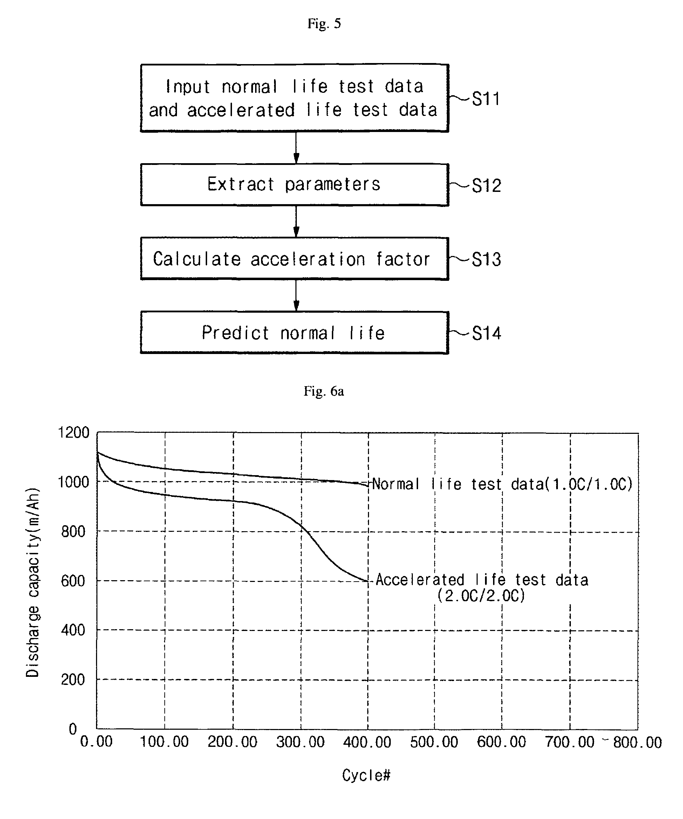

Fig. 5 is a flowchart illustrating an accelerated life estimation method for long life predicting of a secondary battery according to an embodiment of the present invention.

As shown in Fig. 5, the accelerated life estimation method according to the present invention includes a data input step (S11), a parameter extraction step (S12), an acceleration factor calculation step (S13), and a normal (standard cycle) life estimation step (S14). Here, in the data input step (S11), normal life test data (first battery life test data) and accelerated life test data (second battery life test data) are input.

Figs. 6a to 6e illustrate an example of an accelerated life estimation method for long life predicting of a secondary battery according to an embodiment of the present invention. As shown in Fig. 6a, in the data input step (S11), normal life test data and accelerated life test data for the capacity (mAh) relative to the number of charge and/or discharge cycles of the secondary battery.

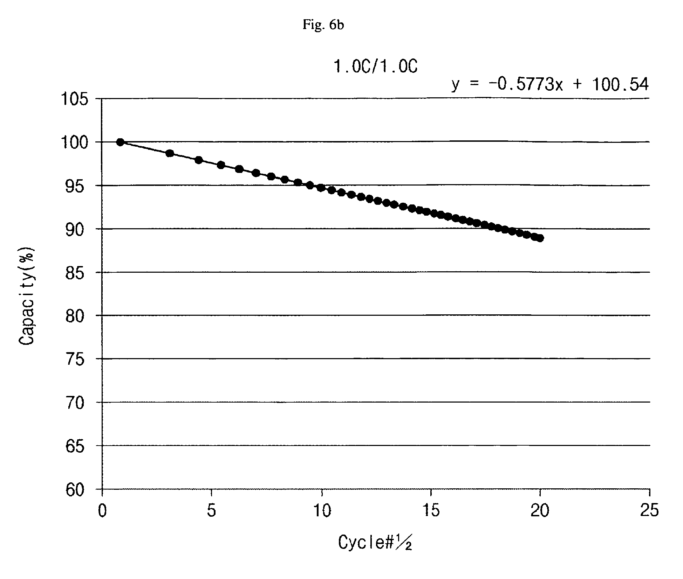

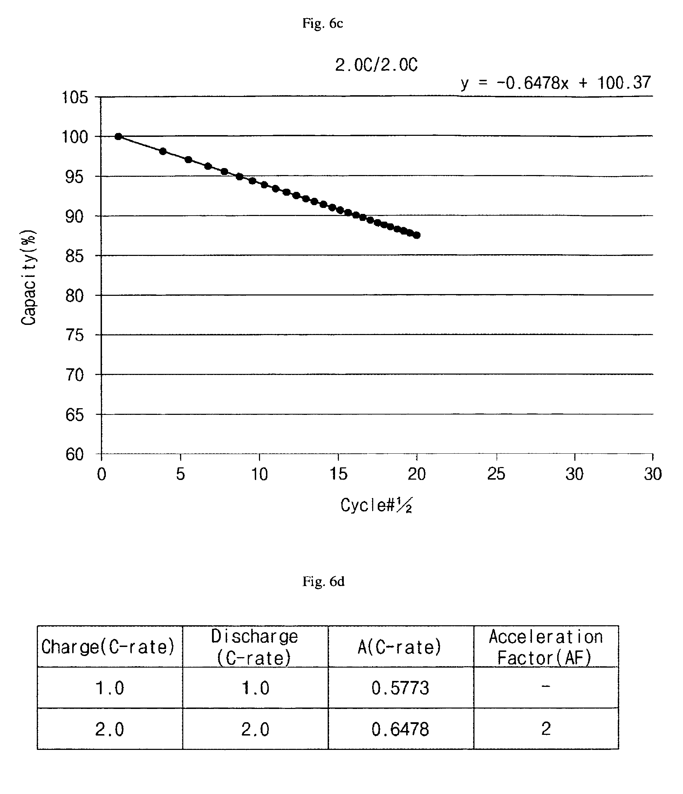

Here, the charge and/or discharge currents and charge and/or discharge cut-off voltages for accelerated life tests may be set to be higher than those for normal life tests. Therefore, as the number of charge and/or discharge cycles of secondary batteries increases, while the capacity of the secondary battery slowly decreases at the normal life test data curve, the capacity of the secondary battery sharply decreases at the accelerated life test data curve. The charge and/or discharge currents 1.0C/1.0C for normal life test data shown in Figs. 6a and 6b, and the charge and/or discharge currents 2.0C/2.0C for accelerated life test data shown in Fig. 6c are provided only for a better understanding of the present invention, but the present invention does not limit values of charge and/or discharge currents to those values stated herein.

Meanwhile, the accelerated life test data can be generally obtained by a cycle method or an interval method.

First, in the cycle method, the life (residual capacity ratio) characteristics of the secondary battery are measured according to the number of charge and/or discharge cycles, and accelerated life tests are conducted under other conditions while increasing charge and/or discharge currents.

In one example, while the normal life test data may be values obtained by charging and/or discharging the secondary battery (a first battery) with a first current of approximately 1.0 C per cycle, the accelerated life test data may be values obtained by charging and/or discharging the secondary battery (a second battery) with a second current of approximately 2.0 C per cycle. As described above, the present invention is not limited to the first or second currents stated herein, which are provided only for a better understanding of the present invention. Further, the normal life test data may include cycle and capacity values obtained by charging and/or discharging the secondary battery (a first battery) with a first voltage, and the accelerated life test data may include cycle and capacity values obtained by charging and/or discharging the secondary battery (a second battery) with a second voltage higher or lower than the first voltage. Furthermore, when the first current is different from the second current, the first voltage may be equal to the second voltage. In addition, the cycle method may be applied to a prismatic battery or a pouch type battery, but aspects of the present invention are not limited thereto. The cycle method may also be applied to a cylindrical battery.

Next, in the interval method, accelerated life tests are conducted by allowing the secondary battery to be left at a predetermined temperature (at room temperature (e.g., 25°C) or a temperature higher than room temperature) for a predetermined time. In one example, while the normal life test data may be values obtained by the secondary battery to be left at a first temperature for a first time, the accelerated life test data may be values obtained by allowing the secondary battery to be left at a second temperature higher or lower than the first temperature for a second time shorter or longer than the first time. Furthermore, when the first period is different from the second period, the first temperature may be equal to the second temperature, and when the first temperature is different from the second temperature, the first period may be equal to the second period

The accelerated life test data may be obtained under the same conditions as the normal life test conditions while slightly increasing only the acceleration factor. In addition, the interval method may be applied to a cylindrical battery, but aspects of the present invention are not limited thereto. The interval method may also be applied to a prismatic battery and a pouch type battery.

The cylindrical battery has a current interrupt device installed therein. Therefore, like in the cycle method, when the cylindrical battery is subjected to life tests with increased charge and/or discharge currents and cut-off voltages, the current interrupt device operates, making the cylindrical secondary battery difficult to be tested in the cycle method.

As shown in Figs. 6b and 6c, in the parameter extraction step (S12), slope parameters A are extracted from the input normal life test data and accelerated life test data, respectively. Here, Fig. 6b illustrates transformation result for the normal life test data, and Fig. 6c illustrates transformation result for the accelerated life test data.

As shown in Figs. 6b and 6c, the capacity is transformed from mAh unit to % unit, and the cycle number is transformed from N to $N^{1/2}$. For example, the discharge capacity of 1100 mAh is transformed to 100%, and the cycle number is transformed from 400 to 20.

In addition, the input data are transformed into substantially linear forms using a model equation, $y = Ax + B$, as shown in Figs. 6b and 6c. Of course, a section in which the capacity linearly varies is selected from the transformed data and the slope parameter A is extracted.

In one example, referring to Fig. 6b, the slope parameter A of 0.5773 was extracted by: $y = -0.5773x + 100.54$. In one example, referring to Fig. 6c, the slope parameter A of o. 6478 was extracted by: $y = -0.6478x + 100.37$.

As shown in Fig. 6d, in the acceleration factor calculation step (S13), the acceleration factor (AF) is calculated using the extracted parameter A and below equation. Here, the acceleration factor (AF) for normal life test data is not calculated.

In one example, based on the following semi-empirical life model, the acceleration factor (AF) can be calculated. Here, before explaining the equation associated with the acceleration factor (AF), the semi-empirical life model associated with the capacity and cycle numbers will first be described.

The inventors of the present invention discovered that the capacity of the secondary battery could be semi-empirically defined as:

$$Capacity = C_0 \times \left(1 - A(C - rate, Swing, middle\ SOC) \times (Cycle\#)^{1/2}\right) \quad ...(1)$$

where $C_o$ is an initial capacity, A is a slope parameter, C-rate is a charge and/or discharge current, Swing is a charge and/or discharge cut-off voltage, middle SOC is a middle state of charge (SOC) (e.g., 80%), and cycle# is a number of charge and/or discharge cycles.

As confirmed from the equation (1), the larger the slope parameter A or the number of charge and/or discharge cycles, affected by the charge and/or discharge current and cut-off voltage, the smaller the capacity of the secondary battery. That is to say, as the charge and/or discharge current and cycle numbers are large, the capacity of the secondary battery is sharply reduced.

Meanwhile, the inventors of the present invention discovered that the number of cycles (cycle#) of the secondary battery and time (t) (day) could be semi-empirically defined as:

$$Cycle\# = \frac{12 cycle\#}{1C - rate \times 1 day} \times (C - rate) \times \left( \frac{50\%}{Swing\%} \right) \times t(day) \quad ...(2)$$

As confirmed from the equation (2), the number of cycles (cycle#) of the secondary battery increases as the charge and/or discharge current (C-rate) and the time (t) (day) increase.

Finally, the inventors of the present invention discovered that the acceleration factor (AF) could be calculated using the equations (1) and (2) as:

$$AF = \frac{t(\text{normal})}{t(\text{accelerated})} = \frac{C - rate(a)}{C - rate(n)} \times \frac{Swing(n)}{Swing(a)} \times \left( \frac{A_a(C - rate(a), Swing(a))}{A_n(C - rate(n), Swing(n))} \right)^2$$

$$...(3)$$

where the acceleration factor (AF) is a ratio of normal life test time relative to accelerated life test time, which may be calculated by the charge and/or discharge current (C-rate), the charge and/or discharge cut-off voltage and the slope parameter A. In equation (3), t(normal) is a normal life test time, t(accelerated) is an accelerated life test time, C-rate (n) is the charge and/or discharge current for normal life test, C-rate (a) is the charge and/or discharge current for accelerated life test, Swing (n) is the cut-off voltage for normal life test, Swing (a) is the cut-off voltage for accelerated life test, and $A_n$ is the slope parameter defining a slope of a graph of battery capacity against cycles number at the normal life test, which depends on the current and cut-off voltage, and $A_a$ is a slope parameter defining a slope of a graph of battery capacity against cycles number at the accelerated life test, which depends on the current and cut-off voltage, as described above.

Although not shown, the parameter extraction step (S12) and the acceleration factor calculation step (S13) may be performed using a statistical life analysis model.

The normal life test data and the accelerated life test data are interpret by a statistical method to calculate the acceleration factor (AF). That is to say, a least square method is applied to the normal life test data and the accelerated life test data for the same capacity, thereby calculating the acceleration factor (AF).

In one example, first, in the parameter extraction step (S12), $(x_n, y_n)$ and $(x_a, y_a)$ are extracted from the normal life test data and the accelerated life test data of the secondary battery, respectively. Here, n denotes normal life test conditions, a denotes an accelerated life test conditions, x denotes cycle numbers (cycle#), and y denotes a life (residual capacity ratio).

In addition, in the acceleration factor calculation step (S13), the acceleration factor (AF) can be obtained through comparison and analysis of cycles of the normal life test data and the accelerated life test data for the same capacity. Here, the least square method is used. To this end, a linear equation is obtained from the extracted $(x_n, y_n)$ and $(x_a, y_a)$. In one example, a linear equation for a normal cycle life can be obtained using the following equation:

$$f(x_n) = a_n + b_n(k x_a - x_n), \quad x_{n-1} \le x_n < x_{n+1} \quad ...(4)$$

where $a_n$ denotes the y-intercept, $b_n$ denotes a slope between data of the battery capacity and cycles number at the normal life test, and k denotes a deteriorated acceleration factor. The least square method is applied to the normal life test data and the accelerated life test data for the same capacity and the deteriorated acceleration factor k is obtained using the following equation:

$$k = \frac{\sum [b_n x_a y_a - a_n b_n x_a + b_n^2 x_n x_a]}{\sum [b_n x_a]^2} \quad ...(5)$$

The acceleration factor (AF) can be calculated by the calculated deteriorated acceleration factor k using the following equation:

$$AF = k \times \frac{C - rate(a)}{C - rate(n)} \quad \text{or} \quad k \times (time\_ratio) \quad ...(6)$$

where C-rate (n) is a charge and/or discharge current used in a normal life test, C-rate (a) is a charge and/or discharge current used in an accelerated life test, and time_ratio is a ratio of initial 100 cycles to an evaluation time.

As described above, according to the present invention, the acceleration factor (AF) can be obtained to indicate how much normal life test data is accelerated relative to the accelerated life test data. Since the acceleration factor (AF) is a ratio of a normal life test time to an accelerated life test time, it can be used as one of barometers of interpreting a reduced evaluation time.

For example, in a case where the acceleration factor (AF) is 4, if the normal life test time is 160 days, the accelerated life test time is 40 days, meaning that in a case of the accelerated life test, it takes 40 days to predict a normal life of 160 days.

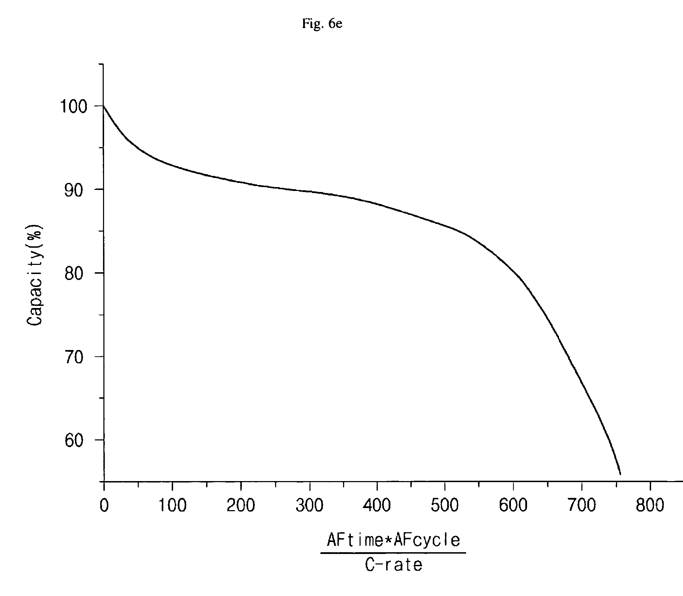

Referring to Fig. 6e, in the normal life prediction step (S14), the acceleration factor (AF) is multiplied with accelerated life test data to obtain a normal life curve of the secondary battery. Here, the Y axis is converted into capacity (%), and the X axis is converted into a product of a time (days) and/or a cycle number. In more detail, the X axis may be converted to $AF_{time}$* $AF_{cycle}$/(C-rate), which will be briefly described.

The acceleration factor (AF), consisting of AF time and AF cycle, may be defined as:

$$AF = AF_{time} * AF_{cycle}...(7)$$

That is to say, $AF_{time}$ and $AF_{cycle}$ may be defined by the equations (8) and (9) below, respectively:

$$AF_{time} = \frac{C - rate(a)}{C - rate(n)} \quad ...(8)$$

$$AF_{cycle} = \frac{Swing(n)}{Swing(a)} \times \left( \frac{A_a(C - rate(a), Swing(a))}{A_n(C - rate(n), Swing(n))} \right)^2 \quad \text{or} \quad \frac{\sum [b_n x_a y_a - a_n b_n x_a + b_n^2 x_n x_a]}{\sum [b_n x_a]^2} \quad ...(9)$$

Therefore, as shown in Fig. 6e, when the X axis is converted to a product of time (acceleration factor $(AF)_{time}$) and cycle (acceleration factor $(AF)_{cycle}$), since a time required for each cycle of charging and discharging varies according to the C-rate, $AF_{time}$* $AF_{cycle}$ may be divided by C-rate.

As described above, according to the present invention, the life evaluation time of the secondary battery can be reduced and a normal cycle life can be accurately predicted under the estimated accelerated conditions.

In addition, according to the present invention, long life prediction of the secondary battery can be achieved within a short time, thereby reducing the overall development time of the secondary battery.

Meanwhile, in the above-described accelerated life estimation method, it is important for capacities obtained under normal and accelerated life test conditions to follow the same change tendency. To this end, the inventors of the present invention demonstrated by analyzing the capacity profile, discharge curve and decomposition of a secondary battery, which will now be described.

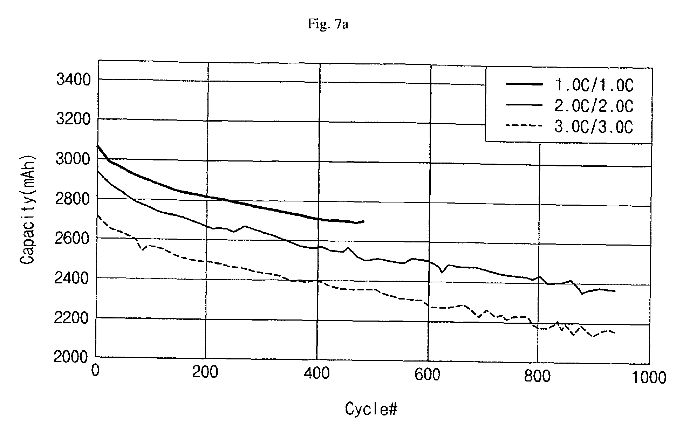

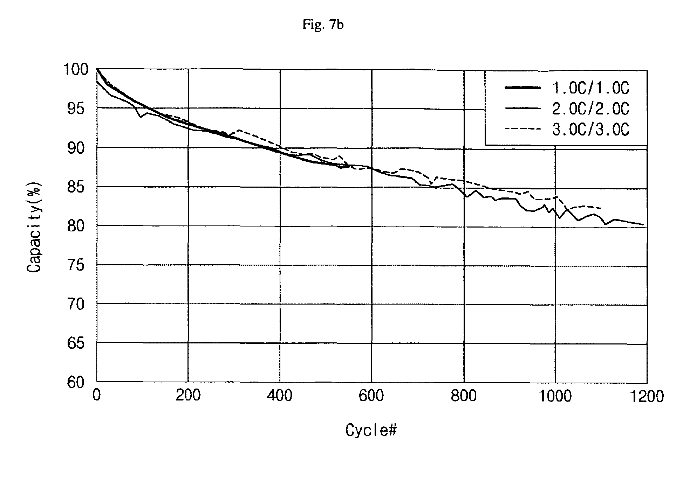

Figs. 7a and 7b illustrate a verification example of evaluation results of an accelerated life estimation method for long life prediction of a secondary battery according to an embodiment of the present invention.

As shown in Fig. 7a, normal life tests are conducted for approximately 500 cycles and accelerated life tests are conducted for approximately 900 cycles.

Here, the X axis indicates the number of charge and/or discharge cycles and the Y axis indicates capacity (mAh). In addition, in the normal life tests, charge and/or discharge currents (C-rate) are 1.0C-1.0C, and in the accelerated life tests, charge and/or discharge currents (C-rate) are 2.0C-2.0C and 3.0C-3.0C. Here, the values of the charge and/or discharge currents (C-rate) are provided only for a better understanding of the present invention, but aspects of the present invention are not limited thereto.

As shown in Fig. 7b, if the acceleration factor (AF) is applied to the accelerated life test data, the normal life test data and the accelerated life test data demonstrate the same capacity change tendency. Therefore, it is considered that the accelerated life estimation method according to the present invention is highly reliable. Here, the X axis indicates the number of charge and/or discharge cycles and the Y axis indicates capacity (%). The unit of the X axis may be the same as that of the X axis shown in Fig. 6e.

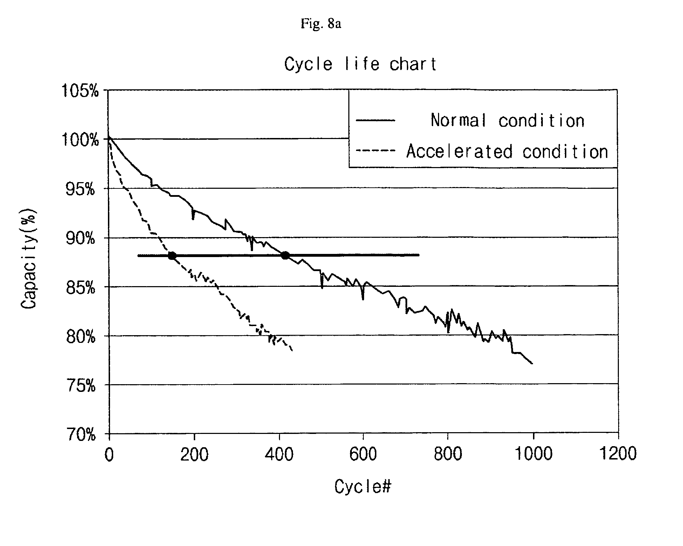

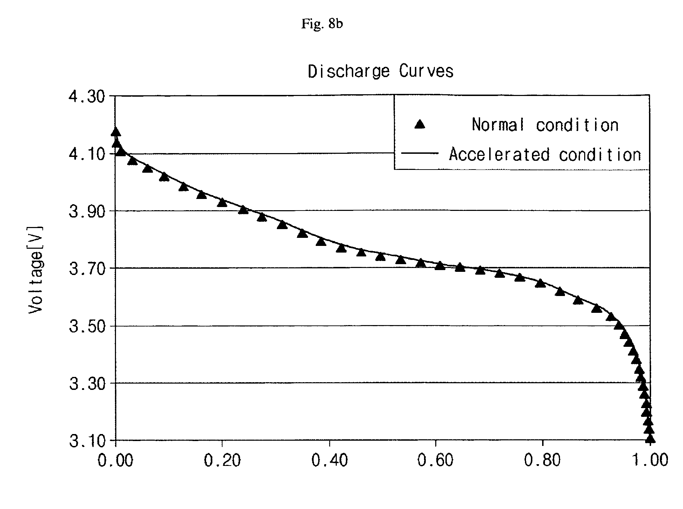

Figs. 8a and 8b illustrate another verification example of evaluation results of an accelerated life estimation method for long life predicting of a secondary battery according to an embodiment of the present invention.

As shown in Fig. 8a, normal life test data and accelerated life test data are obtained, respectively. Here, the X axis indicates the number of cycles and the Y axis indicates capacity (%). In addition, a slope associated with the capacity relative to the number of cycles of the accelerated life test data is greater than that of the capacity relative to the number of cycles of the normal life test data. Therefore, deterioration of the secondary battery occurs in accelerated life tests faster than in normal life tests.

As shown in Fig. 8b, discharge characteristics are measured from the same capacity in the normal life test data and the accelerated life test data, and then normalized to derive the same discharge characteristic curve. That is to say, even if deteriorating conditions for normal life tests and accelerated life tests are different from each other, the secondary battery has the same deterioration mechanism. The discharge curve is one of electrochemical ways for demonstrating the sameness of deterioration mechanism.

In addition, in the present invention, in order to verify the sameness of the deterioration mechanism, the secondary battery is disassembled for analysis and verification. For example, increasing rates in contact resistance of a negative electrode, a deactivated region and charge transfer resistance and an increasing rate in film resistance of a positive electrode were analyzed and verified, and the results thereof showed that the same characteristics were observed from secondary batteries used in normal life tests and accelerated life tests.

As described above, according to the present invention, it was confirmed that there was an error rate of approximately 5% or less or 100 cycles or less between capacity values based on the accelerated life estimation method of the secondary battery and capacity values based on the normal life estimation method of the secondary battery.

Therefore, the long life prediction of the secondary battery based on the accelerated life estimation device and the method thereof according to the present invention is highly reliable.

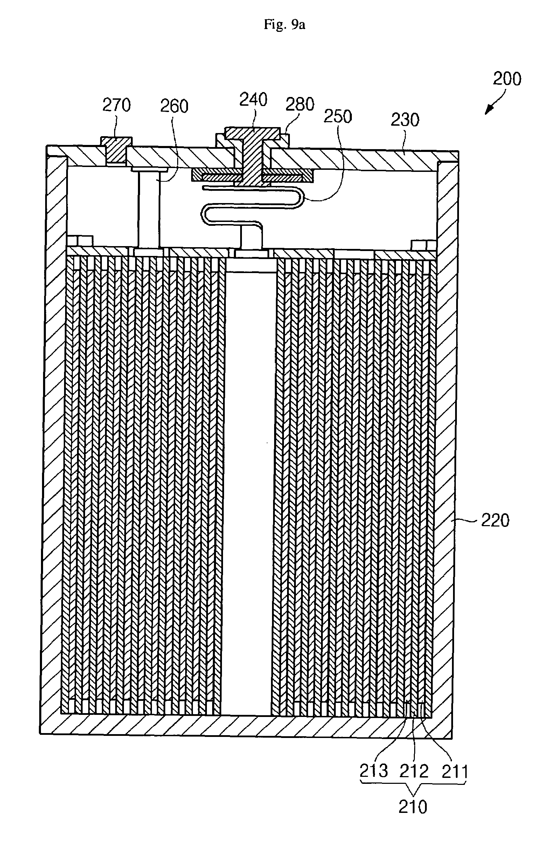

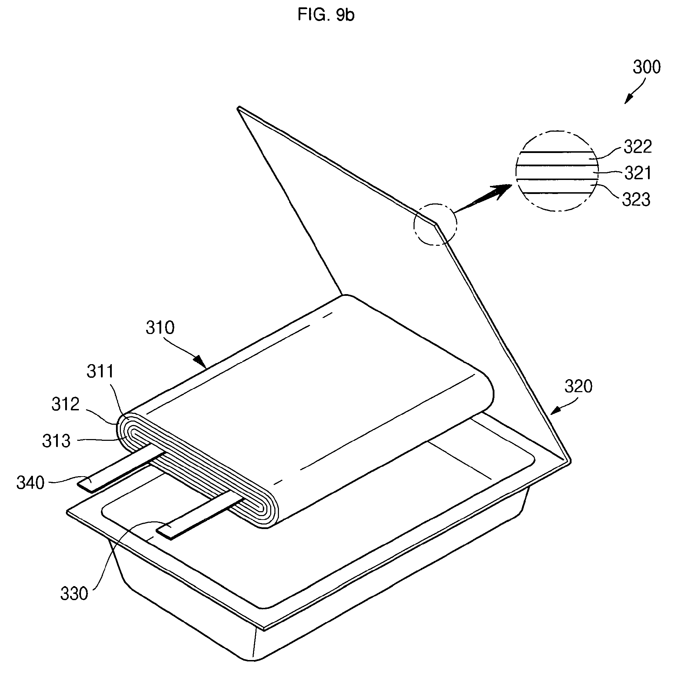

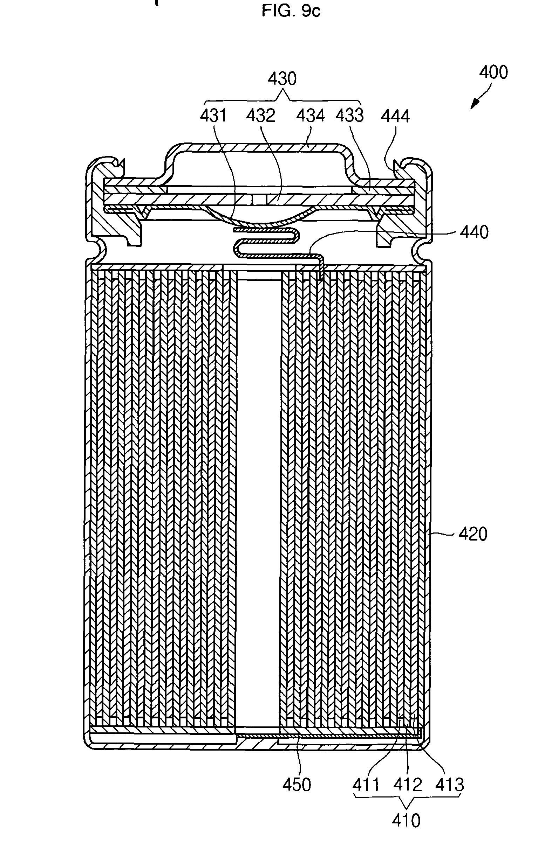

Figs. 9a, 9b and 9c are cross-sectional views illustrating examples of a prismatic battery, a pouch type battery and a cylindrical battery.

As shown in Fig. 9a, the prismatic battery 200 includes an electrode assembly 210 having a positive electrode 211, a separator 212 and a negative electrode 213 stacked therein, a prismatic case 220 accommodating the electrode assembly 210 with an electrolyte (not shown), a cap plate 230 sealing the prismatic case 220, an electrode terminal 240 coupled to the cap plate 230, a positive electrode tab 250 connecting the cap plate 230 to the electrode assembly 210, specifically to the positive electrode 211, and a negative electrode tab 260 connecting the electrode terminal 240 to the electrode assembly 210, specifically to the negative electrode 213. In Fig. 9a, undefined reference numeral 270 denotes an electrolyte injection plug, and undefined reference numeral 280 denotes an insulation gasket.

As shown in Fig. 9b, the pouch type battery 300 includes an electrode assembly 310 having a positive electrode 311, a separator 312 and a negative electrode 313 stacked therein, a pouch case 320 accommodating the electrode assembly 310 with an electrolyte (not shown), a positive electrode cell tab 330 connected to the electrode assembly 310, specifically to the positive electrode 311, and extending to the outside of the pouch case 320, and a negative electrode cell tab 340 connected to the electrode assembly 310, specifically to the negative electrode 313, and extending to the outside of the pouch case 320. Here, the pouch case 320 includes a metal layer 321, a first insulating layer 322 formed on one surface of the metal layer 321, and a second insulating layer 323 formed on the other surface of the metal layer 321.

As shown in Fig. 9c, the cylindrical battery 400 includes an electrode assembly 410 having a positive electrode 411, a separator 412 and a negative electrode 413 stacked therein, a cylindrical case 420 accommodating the electrode assembly 410 with an electrolyte (not shown), a cap assembly 430 sealing the cylindrical case 420, a positive electrode tab 440 electrically connecting the electrode assembly 410, specifically the positive electrode 411, with the cap assembly 430, and a negative electrode tab 450 electrically connecting the electrode assembly 410, specifically the negative electrode 413, with the cylindrical case 420. Here, the cap assembly 430 includes an inversion plate 431 connected to the positive electrode tab 440 and inverted due to increased internal pressure by an over-charge, a circuit board 432 electrically connected to the inversion plate 431 and cutting off an electrical path when the inversion plate 431 is inverted, a conductive ring 433 electrically connected to the circuit board 432, a cap terminal 434 electrically connected to the conductive ring 433, and an insulation gasket 444 insulating the inversion plate 431, the circuit board 432, the conductive ring 433 and the cap terminal 434 from the cylindrical case 420. Here, the inversion plate 431 and the circuit board 432 may be referred to as a current interrupt device, which fundamentally prevents the cylindrical battery 400 from being over-charged or over-discharged.

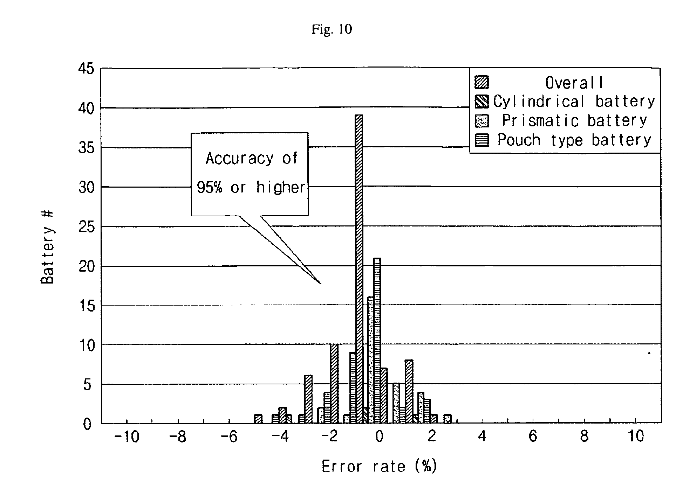

Fig. 10 is a graph illustrating error rates depending on the accelerated life estimation method for long life predicting of a secondary battery according to an embodiment of the present invention.

As shown in Fig. 10, a prismatic battery, a pouch type battery and a cylindrical battery were subjected to normal life tests and accelerated life tests, and the test results showed that there was an error rate of approximately 5% or less in the capacity between the normal and accelerated life tests. That is to say, the normal life value estimated by the accelerated life test according to the present invention has 95% or higher in view of accuracy and reliability. The test results are provided only for a better understanding of the present invention, and the normal life value estimated by the present invention may have 95% or less in view of accuracy and reliability according to the component materials, composition ratio or capacity of the secondary battery.

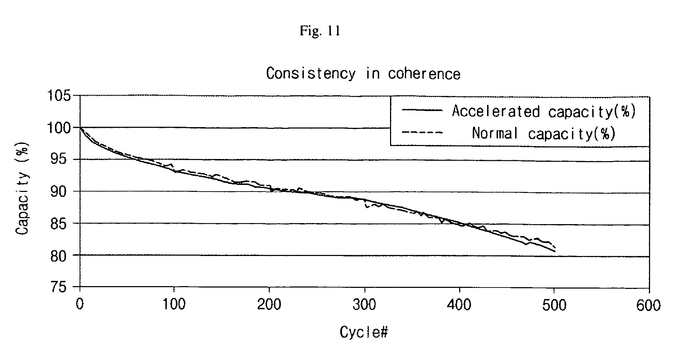

Fig. 11 is a graph illustrating consistency in coherence between normal capacity and accelerated capacity, in which the X axis indicates the number of cycles and the Y axis indicates capacity (%).

As shown in Fig. 11, when the accelerated capacity graph and the normal capacity graph are substantially identical with each other, it is defined that there is consistency in coherence between an accelerated capacity and a normal capacity. Here, the accelerated capacity is obtained by obtaining parameters and acceleration factor from the accelerated life test data and the normal capacity is obtained by a conventional method.

However, when the accelerated capacity graph and the normal capacity graph are not identical with each other, it is defined that there is inconsistency in coherence between an accelerated capacity and a normal capacity.

The inconsistency in coherence usually occurs in the terminal life stage. The inconsistency in coherence may be caused by inappropriate conditions in accelerated life tests, including charge and/or discharge currents (C-rate), charge and/or discharge cut-off voltages, temperature, shelf time and so on. Therefore, it is necessary to empirically set optimal accelerated life test conditions depending on types and characteristics of various batteries. As described above, in a case where there is no consistence in coherence, the accelerated life test conditions are not utilized.

Table 1 below shows results of life tests conducted on prismatic batteries, for example, while varying charge and/or discharge currents (C-Rate) and charge and/or discharge cut-off voltages. Since characteristics of prismatic batteries sold for various customers are different, it is necessary to search optimal charge and/or discharge currents (C-Rate), charge and/or discharge cut-off voltages and acceleration factor (AF) suited to prismatic batteries for various customers. Several typical examples are listed in Table 1.

Table 1

| Type | Conditions | | Acceleration factor (AF) | Evaluation time (day) | |
|------|-----------|--------|--------------------------|----------------------|---------|
| | C-rate | Cut-off | | | |
| 'A' customer oriented | 2.0C/2.0C | 3-5V | 2.0 | 30 | Optimal |
| | 2.5C/2.5C | 3.5V | 7.0 | - | - |
| 'B' customer oriented | 2.0C/2.0C | 3.0V | 2.3 | 27 | Optimal |
| | 2.0C/2.5C | 3.0V | 7.0 | - | - |
| 'C' customer oriented | 2.0C/2.0C | 3.1V | 3.0 | 43 | Optimal |
| | 2.0C/2.5C | 3.1V | 4.0 | - | - |

Table 2 below shows that normal life test evaluation time and accelerated life test evaluation time based on the results shown in Table 1.

Table 2

| Customer | Normal | | Accelerated | | |
|---|---|---|---|---|---|
| | Evaluation time (day) | Evaluation conditions | Evaluation conditions | Acceleration factor (AF) | Evaluation time (day) |
| 'A' customer oriented | 55 | 1.0C/1.0C | 2.0C/2.0C | 2.0 | 30 |
| 'B' customer oriented | 60 | 1.0C/1.0C | 2.0C/2.0C | 2.3 | 27 |
| 'C' customer oriented | 150 | 1.0C/1.0C | 2.0C/2.0C | 3.0 | 40 |

As listed in Table 2, in a case of an 'A' customer oriented secondary battery, for example, while 55 days were taken for normal evaluation, an evaluation time of 30 days was sufficient for accelerated evaluation according to the present invention. In addition, in a case of a 'B' customer oriented secondary battery, while 60 days were taken for normal evaluation, an evaluation time of 27 days was sufficient for accelerated evaluation according to the present invention. In addition, in a case of a 'C' customer oriented secondary battery, while 150 days were taken for normal evaluation, an evaluation time of 40 days was sufficient for accelerated evaluation according to the present invention. Of course, the normal life test evaluation time and the accelerated life test evaluation time are provided only for a better understanding of the present invention, but aspects of the present invention are not limited thereto.

As described above, in the accelerated life estimation device and method thereof according to the present invention, the life evaluation time of the secondary battery can be greatly reduced, compared to the conventional life estimation device and method thereof.

Table 3 below shows normal evaluation time and accelerated evaluation time conducted on pouch type batteries. Here, normal and accelerated life tests were conducted according to product characteristics of pouch type batteries, rather than customer oriented type. In a case of 'A' group, a negative electrode active material relative to a positive electrode active material was 1.6 times or greater and a volume energy density was 500 Wh/L. In a case of 'B' group, a negative electrode active material relative to a positive electrode active material was 1.6 times or less and a current density ranges from 2.8 to 2.99. In a case of 'C' group, a negative electrode active material relative to a positive electrode active material was 1.6 times or less and a current density was 2.8 or less.

Table 3

| Group | Normal Conditions | | Accelerated Conditions | | |
|---|---|---|---|---|---|
| | Evaluation Time (day) | Evaluation Conditions | Evaluation Conditions | Acceleration factor (AF) | Evaluation Time (day) |
| A | 90 | 1.0C/1.0C | 1.9C~2.3C | 3.0 | 30 |
| B~C | 76 | 1-0C/1.5C | 2.3C~2.5C | 2.8 | 27 |

As listed in Table 3, in a case of an 'A' group secondary battery, for example, while 90 days were taken for normal evaluation, an evaluation time of 30 days was sufficient for accelerated evaluation according to the present invention. In addition, in cases of 'B' and 'C' group secondary batteries, while 76 days were taken for normal evaluation, an evaluation time of 27 days was sufficient for accelerated evaluation according to the present invention. As described above, the normal life test evaluation time and the accelerated life test evaluation time are provided only for a better understanding of the present invention, but aspects of the present invention are not limited thereto.

As described above, in the accelerated life estimation device and method thereof according to the present invention, the life evaluation time of the secondary battery can be greatly reduced, compared to the conventional life estimation device and method thereof.

Table 4 below shows results of life tests conducted on cylindrical batteries, for example, using an interval method while varying temperature and shelf time.

Table 4

| Conditions | | Acceleration factor (AF) | Evaluation time (day) | Analysis |
|---|---|---|---|---|
| Temperature (°C) | Shelf time (day) | | | |
| 30 | 8 | 1.4 | 71 | - |
| | 48 | 1.0 | 86 | - |
| 40 | 8 | 1.5 | 57 | - |
| | 48 | 1.3 | 70 | - |
| 50 | 8 | 2.0 | 43 | Optimal |
| | 48 | 1.7 | 53 | - |
| 60 | 8 | 3.0 | 30 | - |
| | 48 | 1.7 | 51 | - |

As listed in Table 4, in cases of cylindrical batteries, optimal conditions were a temperature of 50°C, and a shelf time of 8 days. The evaluation time was reduced from 90 days under normal conditions to 43 days under accelerated conditions. As described above, the normal life test evaluation time and the accelerated life test evaluation time are provided only for a better understanding of the present invention, but aspects of the present invention are not limited thereto.

Table 5 below shows results of accelerated life tests conducted on cylindrical batteries at room temperature. Here, a lithium cobalt oxide (LCO) type cylindrical battery including a large amount of cobalt (Co) as a positive electrode active material was selected as the cylindrical battery to be evaluated.

Table 5

| Type | Conditions | Acceleration factor (AF) | Evaluation time (day) | |
|---|---|---|---|---|
| A type | 2.0C/2.0C | 1.5 | 30 | Applicable |
| | 2.0C/2.0C | 2.0 | 23 | - |
| B type | 2.5C/2.5C | 2.0 | 22 | - |
| | 1.0C/2.5C | 1.8 | 25 | Applicable |

As listed in Table 5, the results of accelerated life tests conducted on the cylindrical batteries at room temperature showed that the evaluation time was reduced from 45 days under normal conditions to 30 days and 25 days under accelerated conditions. As described above, the normal life test evaluation time and the accelerated life test evaluation time are provided only for a better understanding of the present invention, but aspects of the present invention are not limited thereto.

While the present invention has been particularly shown and described with reference to exemplary embodiments of an accelerated life estimation device for long life prediction of a secondary battery and a method thereof, it will be understood by those of ordinary skill in the art that various changes in form and details may be made therein without departing from the scope of the present invention as defined by the following claims.

**Claims**

1.    A device for estimating the battery life of secondary batteries, comprising:

a data input unit (110) arranged to receive first test data from a first secondary battery and second test data from a second secondary battery of the same type as the first secondary battery, wherein the first and second test data are for estimating the battery life of the secondary batteries, and the second test data is determined under conditions that accelerate the deterioration of the second secondary battery compared to conditions under which the first test data is obtained;
a data processing unit (120) arranged to calculate an acceleration factor from the first and the second test data and arranged to estimate the life of the secondary batteries from the second test data and the acceleration factor.

2. The device of claim 1, wherein the data processing unit comprises:

   a parameter extraction unit (121) arranged to extract parameters from the first and the second test data;
   an acceleration factor calculation unit (122) arranged to calculate the acceleration factor from the extracted parameters; and
   a normal life prediction unit (123) arranged to estimate the life of the secondary batteries.

3. The device of claim 1 or 2, wherein the first test data include cycle and capacity values obtained by charging and/or discharging the first secondary battery with a first current, and the second test data include cycle and capacity values obtained by charging and/or discharging the second secondary battery of the same type as the first secondary battery with a second current greater than the first current.

4. The device of claim 1 or 2, wherein the first test data includes cycle and capacity values obtained by leaving the first secondary battery at a first temperature for a first predetermined period, and the second test data includes cycle and capacity values obtained by leaving the second secondary battery at a second temperature for a second predetermined period, the second temperature being higher or lower than the first temperature, or the second temperature being equal to the first temperature, and the second predetermined period being shorter or longer than the first predetermined period, or the second predetermined period being equal to the first predetermined period.

5. The device of any one of the preceding claims, wherein the data processing unit is arranged to calculate the acceleration factor using a semi-empirical life model of the secondary batteries or a statistical life analysis model of the secondary batteries.

6. The device of any one of the preceding claims, wherein the data processing unit is arranged to calculate the acceleration factor using the equation:

$$AF = \frac{t(\text{normal})}{t(\text{accelerated})} = \frac{C - rate(a)}{C - rate(n)} \times \frac{Swing(n)}{Swing(a)} \times \left( \frac{A_a(C - rate(a), Swing(a))}{A_n(C - rate(n), Swing(n))} \right)^2$$

where t(normal) is a normal life test time for providing the first test data, t(accelerated) is an accelerated life test time for providing the second test data; C-rate (n) is a charge and/or discharge current used in a normal life test, C-rate (a) is a charge and/or discharge current used in an accelerated life test, Swing (n) is a charge and/or discharge cut-off voltage used in the normal life test, Swing (a) is a charge and/or discharge cut-off voltage used in the accelerated life test, $A_n$ is a slope parameter defining a slope of a graph of battery capacity against number of cycles at the normal life test time, and $A_a$ is a slope parameter defining a slope of a graph of battery capacity against number of cycles at the accelerated test time.

7. The device of any one of claims 1 to 5, wherein the data processing unit is arranged to calculate the acceleration factor using the equation:

$$AF = k \times \frac{C - rate(a)}{C - rate(n)} \quad \text{or} \quad k \times (time\_ratio)$$

where C-rate (n) is a charge and/or discharge current used in a normal life test for providing the first test data, C-rate (a) is a charge and/or discharge current used in an accelerated life test for providing the second test data, time_ratio is a ratio of an initial 100 cycles to an evaluation time and k is a deteriorated acceleration factor which is calculated using the following equation:

$$k = \frac{\sum [b_n x_a y_a - a_n b_n x_a + b_n^2 x_n x_a]}{\sum [b_n x_a]^2}$$

where the subscript n denotes a normal life test condition, the subscript a denotes an accelerated life test condition, x denotes cycle numbers, y denotes a residual capacity ratio, $b_n$ denotes a slope between data of the battery capacity and cycle numbers at the normal lifetime test, and $a_n$ denotes the y-intercept.

8. The device of any one of the preceding claims, wherein the data processing unit is arranged to calculate the estimated battery life by multiplying the acceleration factor AF by the second test data.

9. The device of any one of the preceding claims, further comprising a storage device arranged to store one or more of the first and the second test data, the extracted parameters, the acceleration factor and the estimated life of the secondary batteries.

10. The device of any one of the preceding claims, further comprising a display device arranged to display one or more of the first and the second test data, the extracted parameters, the acceleration factor and the estimated life of the secondary batteries.

11. The device of any one of the preceding claims, wherein the first and/or the second test data comprise one or more of residual capacity ratio, cycle numbers, charge and/or discharge currents and charge and/or discharge cut-off voltages.

12. The device of any one of the preceding claims when dependent on claim 2, wherein the parameter extraction unit 121 is arranged to extract a slope parameter for a residual capacity ratio relative to cycles from the first and the second test data.

13. The device of claim 1 or 2, wherein the first test data includes cycle and capacity values obtained by charging and/or discharging the first secondary battery with a first voltage, and the second test data includes cycle and capacity values obtained by charging and/or discharging the second secondary battery with a second voltage, the second voltage being higher or lower than the first voltage, or the second voltage being equal to the second voltage.

14. A method of estimating the battery life of secondary batteries, comprising:

receiving first test data from a first secondary battery and second test data from a second secondary battery of the same type as the first secondary battery, wherein the first and second test data are for estimating the battery life of the secondary batteries, and the second test data is determined under conditions that accelerate the deterioration of the second secondary battery compared to conditions under which the first test data is obtained; calculating an acceleration factor from the first and the second test data; and estimating the life of the secondary batteries from the second test data and the acceleration factor.

**Patentansprüche**

1. Vorrichtung zum Abschätzen der Batterielebensdauer von Sekundärbatterien, umfassend:

eine Dateneingabeeinheit (110), die gestaltet ist, erste Testdaten von einer ersten Sekundärbatterie und zweite Testdaten von einer zweiten Sekundärbatterie derselben Art wie die erste Sekundärbatterie zu empfangen, wobei die ersten und zweiten Testdaten zum Abschätzen der Batterielebensdauer der Sekundärbatterien dienen und die zweiten Testdaten unter Bedingungen bestimmt werden, die im Vergleich zu Bedingungen, unter denen die ersten Testdaten erhalten werden, die Verschlechterung der zweiten Sekundärbatterie beschleunigen; eine Datenverarbeitungseinheit (120), die gestaltet ist, aus den ersten und zweiten Testdaten einen Beschleunigungsfaktor zu berechnen, und die gestaltet ist, aus den zweiten Testdaten und dem Beschleunigungsfaktor die Lebensdauer der Sekundärbatterien zu schätzen.

2. Vorrichtung nach Anspruch 1, wobei die Datenverarbeitungseinheit Folgendes umfasst:

eine Parameterextraktionseinheit (121), die gestaltet ist, aus den ersten und zweiten Testdaten Parameter zu extrahieren; eine Beschleunigungsfaktorberechnungseinheit (122), die gestaltet ist, aus den extrahierten Parametern den Beschleunigungsfaktor zu berechnen; und eine Normallebensdauervorhersageeinheit (123), die gestaltet ist, die Lebensdauer der Sekundärbatterien zu schätzen.

3. Vorrichtung nach Anspruch 1 oder 2, wobei die ersten Testdaten Zyklus- und Kapazitätswerte beinhalten, die durch Laden und/oder Entladen der ersten Sekundärbatterie mit einem ersten Strom erhalten werden, und wobei die zweiten Testdaten Zyklus- und Kapazitätswerte beinhalten, die durch Laden und/oder Entladen der zweiten Sekundärbatterie derselben Art wie die erste Sekundärbatterie mit einem zweiten Strom, der größer als der erste Strom ist, erhalten werden.

4. Vorrichtung nach Anspruch 1 oder 2, wobei die ersten Testdaten Zyklus- und Kapazitätswerte beinhalten, die erhalten werden, indem die erste Sekundärbatterie über einen ersten vorbestimmten Zeitraum bei einer ersten Temperatur aufbewahrt wird, und wobei die zweiten Testdaten Zyklus- und Kapazitätswerte beinhalten, die erhalten werden, indem die zweite Sekundärbatterie über einen zweiten vorbestimmten Zeitraum bei einer zweiten Temperatur aufbewahrt wird, wobei die zweite Temperatur höher oder niedriger als die erste Temperatur ist oder wobei die zweite Temperatur so hoch wie die erste Temperatur ist und der zweite vorbestimmte Zeitraum kürzer oder länger als der erste vorbestimmte Zeitraum ist oder wobei der zweite vorbestimmte Zeitraum so lang wie der erste vorbestimmte Zeitraum ist.

5. Vorrichtung nach einem der vorangehenden Ansprüche, wobei die Datenverarbeitungseinheit gestaltet ist, den Beschleunigungsfaktor anhand eines halbempirischen Lebensdauermodells der Sekundärbatterien oder eines statistischen Lebensdaueranalysemodells der Sekundärbatterien zu berechnen.

6. Vorrichtung nach einem der vorangehenden Ansprüche, wobei die Datenverarbeitungseinheit gestaltet ist, den Beschleunigungsfaktor anhand folgender Gleichung zu berechnen:

$$AF = \frac{t(\text{normal})}{t(\text{accelerated})} = \frac{C-rate(a)}{C-rate(n)} \times \frac{Swing(n)}{Swing(a)} \times \left( \frac{A_a(C-rate(a), Swing(a))}{A_n(C-rate(n), Swing(n))} \right)^2$$

wobei t(normal) eine Normallebensdauertestzeit zum Bereitstellen der ersten Testdaten ist, t(accelerated) eine Beschleunigungslebensdauertestzeit zum Bereitstellen der zweiten Testdaten ist; C-rate (n) ein in einem Normallebensdauertest angewandter Lade- und/oder Entladestrom ist, C-rate (a) ein in einem Beschleunigungslebensdauertest angewandter Lade- und/oder Entladestrom ist, Swing (n) eine im Normallebensdauertest angewandte Lade- und/oder Entladeschlussspannung ist, Swing (a) eine im Beschleunigungslebensdauertest angewandte Lade- und/oder Entladeschlussspannung ist, An ein Steigungsparameter ist, der eine Steigung eines Graphs der Batteriekapazität gegen die Zyklenzahl bei der Normallebensdauertestzeit definiert, und $A_a$ ein Steigungsparameter ist, der eine Steigung eines Graphs der Batteriekapazität gegen die Zyklenzahl bei der Beschleunigungstestzeit definiert.

7. Vorrichtung nach einem der Ansprüche 1 bis 5, wobei die Datenverarbeitungseinheit gestaltet ist, den Beschleunigungsfaktor anhand folgender Gleichung zu berechnen:

$$AF = k \times \frac{C-rate(a)}{C-rate(n)} \text{ or } k \times (time\_ratio)$$

wobei C-rate (n) ein in einem Normallebensdauertest zum Bereitstellen der ersten Testdaten angewandter Lade- und/oder Entladestrom ist, C-rate(a) ein in einem Beschleunigungslebensdauertest zum Bereitstellen der zweiten Testdaten angewandter Lade- und/oder Entladestrom ist, time_ratio ein Verhältnis von ursprünglich 100 Zyklen zu einer Bewertungszeit ist und k ein Verschlechterungsbeschleunigungsfaktor ist, der anhand der folgenden Gleichung berechnet wird:

$$k = \frac{\sum [b_n x_a y_a - a_n b_n x_a + b_n^2 x_n x_a]}{\sum [b_n x_a]^2}$$

wobei der Index n eine Normallebensdauertestbedingung bezeichnet, der Index a eine Beschleunigungslebensdauertestbedingung bezeichnet, x die Zyklenzahlen bezeichnet, y ein Restkapazitätsverhältnis bezeichnet, $b_n$ eine

Steigung zwischen Daten der Batteriekapazität und der Zyklenzahlen beim Normallebensdauertest bezeichnet, und $a_n$ den y-Schnittpunkt bezeichnet.

8. Vorrichtung nach einem der vorangehenden Ansprüche, wobei die Datenverarbeitungseinheit gestaltet ist, die geschätzte Batterielebensdauer durch Multiplizieren des Beschleunigungsfaktors AF mit den zweiten Testdaten zu berechnen.

9. Vorrichtung nach einem der vorangehenden Ansprüche, ferner umfassend eine Speichervorrichtung, die gestaltet ist, eine(n) oder mehrere der ersten und zweiten Testdaten, der extrahierten Parameter, des Beschleunigungsfaktors und der geschätzten Lebensdauer der Sekundärbatterien zu speichern.

10. Vorrichtung nach einem der vorangehenden Ansprüche, ferner umfassend eine Anzeigevorrichtung, die gestaltet ist, eine(n) oder mehrere der ersten und zweiten Testdaten, der extrahierten Parameter, des Beschleunigungsfaktors und der geschätzten Lebensdauer der Sekundärbatterien anzuzeigen.

11. Vorrichtung nach einem der vorangehenden Ansprüche, wobei die ersten und/oder die zweiten Testdaten eine(n) oder mehrere aus Restkapazitätsverhältnis, Zyklenzahlen, Lade- und/oder Entladeströmen und Lade- und/oder Entladeschlussspannungen umfassen.

12. Vorrichtung nach einem der vorangehenden Ansprüche, soweit rückbezogen auf Anspruch 2, wobei die Parameterextraktionseinheit 121 gestaltet ist, aus den ersten und den zweiten Testdaten einen Steigungsparameter für ein Restkapazitätsverhältnis in Bezug auf Zyklen zu extrahieren.

13. Vorrichtung nach Anspruch 1 oder 2, wobei die ersten Testdaten Zyklus- und Kapazitätswerte beinhalten, die durch Laden und/oder Entladen der ersten Sekundärbatterie mit einer ersten Spannung erhalten werden, und die zweiten Testdaten Zyklus- und Kapazitätswerte beinhalten, die durch Laden und/oder Entladen der zweiten Sekundärbatterie mit einer zweiten Spannung erhalten werden, wobei die zweite Spannung größer oder kleiner als die erste Spannung ist oder wobei die zweite Spannung so groß wie die zweite Spannung ist.

14. Verfahren zum Abschätzen der Batterielebensdauer von Sekundärbatterien, umfassend:

   Empfangen erster Testdaten von einer ersten Sekundärbatterie und zweiter Testdaten von einer zweiten Sekundärbatterie derselben Art wie die erste Sekundärbatterie, wobei die ersten und zweiten Testdaten zum Abschätzen der Batterielebensdauer der Sekundärbatterien dienen und die zweiten Testdaten unter Bedingungen bestimmt werden, die Vergleich zu Bedingungen, unter denen die ersten Testdaten erhalten werden, die Verschlechterung der zweiten Sekundärbatterie im beschleunigen;
   Berechnen eines Beschleunigungsfaktors aus den ersten und den zweiten Testdaten und
   Abschätzen der Lebensdauer der Sekundärbatterien aus den zweiten Testdaten und dem Beschleunigungsfaktor.

**Revendications**

1. Dispositif pour estimer la durée de vie de batterie de batteries secondaires, comprenant :

   une unité d'entrée de données (110) agencée pour recevoir des premières données de test d'une première batterie secondaire et des deuxièmes données de test d'une deuxième batterie secondaire du même type que la première batterie secondaire, dans lequel les premières et deuxièmes données de test servent à estimer la durée de vie de batterie des batteries secondaires, et les deuxièmes données de test sont déterminées dans des conditions qui accélèrent la détérioration de la deuxième batterie secondaire comparées aux conditions dans lesquelles les premières données de test sont obtenues ;
   une unité de traitement de données (120) agencée pour calculer un facteur d'accélération à partir des premières et deuxièmes données de test et agencée pour estimer la durée de vie des batteries secondaires à partir des deuxièmes données de test et du facteur d'accélération.

2. Dispositif selon la revendication 1, dans lequel l'unité de traitement de données comprend :

   une unité d'extraction de paramètre (121) agencée pour extraire des paramètres des premières et deuxièmes données de test ;
une unité de calcul de facteur d'accélération (122) agencée pour calculer le facteur d'accélération à partir des paramètres extraits ; et
une unité de prédiction de durée de vie normale (123) agencée pour estimer la durée de vie des batteries secondaires.

3. Dispositif selon la revendication 1 ou 2, dans lequel les premières données de test comprennent des valeurs de cycle et de capacité obtenues en chargeant et/ou déchargeant la première batterie secondaire avec un premier courant, et les deuxièmes données de test comprennent des valeurs de cycle et de capacité obtenues en chargeant et/ou déchargeant la deuxième batterie secondaire du même type que le première batterie secondaire avec un deuxième courant supérieur au premier courant.

4. Dispositif selon la revendication 1 ou 2, dans lequel les premières données de test comprennent des valeurs de cycle et de capacité obtenues en laissant la première batterie secondaire à une première température pendant une première période prédéterminée, et les deuxièmes données de test comprennent des valeurs de cycle et de capacité obtenues en laissant la deuxième batterie secondaire à une deuxième température pendant une deuxième période prédéterminée, la deuxième température étant supérieure ou inférieure à la première température, ou la deuxième température étant égale à la première température, et la deuxième période prédéterminée étant plus courte ou plus longue que la première période prédéterminée, ou la deuxième période prédéterminée étant égale à la première période prédéterminée.

5. Dispositif selon l'une quelconque des revendications précédentes, dans lequel l'unité de traitement de données est agencée pour calculer le facteur d'accélération en utilisant un modèle de durée de vie semi-empirique des batteries secondaires ou un modèle d'analyse de durée de vie statistique des batteries secondaires.

6. Dispositif selon l'une quelconque des revendications précédentes, dans lequel l'unité de traitement de données est agencée pour calculer le facteur d'accélération en utilisant l'équation :

$$AF = \frac{t(\text{normal})}{t(\text{accelerated})} = \frac{C-rate(a)}{C-rate(n)} \times \frac{Swing(n)}{Swing(a)} \times \left( \frac{A_a\big(C-rate(a), Swing(a)\big)}{A_n\big(C-rate(n), Swing(n)\big)} \right)^2$$

où t (normal) est un temps de test de durée de vie normal pour fournir les premières données de test, t(accelerated) est un temps de test de durée de vie accéléré pour fournir les deuxièmes données de test ; C-rate(n) est un courant de charge et/ou de décharge utilisé dans un test de durée de vie normal, C-rate(a) est un courant de charge et/ou de décharge utilisé dans un test de durée de vie accéléré, Swing(n) est une tension de coupure de charge et/ou de décharge utilisée dans le test de durée de vie normal, Swing(a) est une tension de coupure de charge et/ou de décharge utilisée dans le test de durée de vie accéléré, $A_n$ est un paramètre de pente définissant une pente d'un graphe de capacité de batterie en fonction du nombre de cycles pour le temps de test de durée de vie normal, et $A_a$ est un paramètre de pente définissant une pente d'un graphe de capacité de batterie en fonction du nombre de cycles pour le temps de test de durée de vie accéléré.

7. Dispositif selon l'une quelconque des revendications 1 à 5, dans lequel l'unité de traitement de données est agencée pour calculer le facteur d'accélération en utilisant l'équation :

$$AF = k \times \frac{C-rate(a)}{C-rate(n)} \quad \text{ou} \quad k \times (time\_ratio)$$

où C-rate(n) est un courant de charge et/ou de décharge utilisé dans un test de durée de vie normal pour fournir les premières données de test, C-rate(a) est un courant de charge et/ou de décharge utilisé dans un test de durée de vie accéléré pour fournir les deuxièmes données de test, time_ratio est un rapport entre 100 cycles initiaux et un temps d'évaluation et k est un facteur d'accélération détérioré qui est calculé en utilisant l'équation suivant :

$$k = \frac{\sum [b_n x_a y_a - a_n b_n x_a + b_n^2 x_n x_a]}{\sum [b_n x_a]^2}$$

où l'indice n désigne une condition de test de durée de vie normal, l'indice a désigne une condition de test de durée de vie accéléré, x désigne des nombres de cycles, y désigne un rapport de capacité résiduelle, $b_n$ désigne une pente entre des données de la capacité de batterie et des nombres de cycles pour le test de durée de vie normal, et $a_n$ désigne le croisement de y.

8. Dispositif selon l'une quelconque des revendications précédentes, dans lequel l'unité de traitement de données est agencée pour calculer la durée de vie de batterie estimée en multipliant le facteur d'accélération AF par les deuxièmes données de test.

9. Dispositif selon l'une quelconque des revendications précédentes, comprenant en outre un dispositif de mémorisation agencé pour mémoriser l'un ou plusieurs des premières et deuxièmes données de test, des paramètres extraits, du facteur d'accélération et de la durée de vie estimée des batteries secondaires.

10. Dispositif selon l'une quelconque des revendications précédentes, comprenant en outre un dispositif d'affichage agencé pour afficher l'un ou plusieurs des premières et deuxièmes données de test, des paramètres extraits, du facteur d'accélération et de la durée de vie estimée des batteries secondaires.

11. Dispositif selon l'une quelconque des revendications précédentes, dans lequel les premières et/ou deuxièmes données de test comprennent l'un ou plusieurs du rapport de capacité résiduelle, des nombres de cycles, des courants de charge et/ou de décharge et des tensions de coupure de charge et/ou de décharge.

12. Dispositif selon l'une quelconque des revendications précédentes lorsqu'elles dépendent de la revendication 2, dans lequel l'unité d'extraction de paramètre (121) est agencée pour extraire un paramètre de pente pour un rapport de capacité résiduelle par rapport à des cycles des premières et deuxièmes données de test.

13. Dispositif selon la revendication 1 ou 2, dans lequel les premières données de test comprennent des valeurs de cycle et de capacité obtenues en chargeant et/ou déchargeant la première batterie secondaire avec une première tension, et les deuxièmes données de test comprennent des valeurs de cycle et de capacité obtenues en chargeant et/ou déchargeant la deuxième batterie secondaire avec une deuxième tension, la deuxième tension étant supérieure ou inférieure à la première tension, ou la deuxième tension étant égale à la première tension.

14. Procédé d'estimation de la durée de vie de batterie de batteries secondaires, comprenant :

la réception de premières données de test d'une première batterie secondaire et de deuxièmes données de test d'une deuxième batterie secondaire du même type que la première batterie secondaire, dans lequel les premières et deuxièmes données de test servent à estimer la durée de vie de batterie des batteries secondaires, et les deuxièmes données de test sont déterminées dans des conditions qui accélèrent la détérioration de la deuxième batterie secondaire comparées aux conditions dans lesquelles les premières données de test sont obtenues ;
le calcul d'un facteur d'accélération à partir des premières et deuxièmes données de test ; et
l'estimation de la durée de vie des batteries secondaires à partir des deuxièmes données de test et du facteur d'accélération.

Fig. 1

Fig. 2

Fig. 3a

Capacity(%)

80%

Time

Normal(Standard cycle)
life evaluation time

Fig. 3b

Fig. 3c

Fig. 3d

Capacity(%)

80%

Evaluation time

Time

Normal(Standard cycle)
life evaluation time

Fig. 3e

Capacity(%)

Trust

80%

Evaluation time
(1)

Estimated life time
(2)
A months
(or B cycle)

Time

Normal(Standard cycle)
life evaluation time

Fig. 3f

Capacity(%)

80%

Evaluation time  Estimated life time

Trust  Time

Normal(Standard cycle)
life evaluation time

Fig. 4

100

120

Parameter extraction unit ~121

110

Data
input
unit

Acceleration factor calculation unit ~122

140

Display
unit

Normal(Standard cycle) life prediction unit ~123

Storage unit ~130

Fig. 5

```
┌─────────────────────────────────┐
│   Input normal life test data   │
│  and accelerated life test data │ ～S11
└─────────────────────────────────┘
                 │
                 ▼
┌─────────────────────────────────┐
│       Extract parameters        │ ～S12
└─────────────────────────────────┘
                 │
                 ▼
┌─────────────────────────────────┐
│   Calculate acceleration factor │ ～S13
└─────────────────────────────────┘
                 │
                 ▼
┌─────────────────────────────────┐
│       Predict normal life       │ ～S14
└─────────────────────────────────┘
```

Fig. 6a

Fig. 6b

1.0C/1.0C

$y = -0.5773x + 100.54$

Fig. 6c

2.0C/2.0C

$y = -0.6478x + 100.37$

Fig. 6d

| Charge(C-rate) | Discharge (C-rate) | A(C-rate) | Acceleration Factor(AF) |
|:---:|:---:|:---:|:---:|
| 1.0 | 1.0 | 0.5773 | − |
| 2.0 | 2.0 | 0.6478 | 2 |

Fig. 6e

Fig. 7a

Fig. 7b

Fig. 8a

## Cycle life chart

Fig. 8b

Discharge Curves

Fig. 9a

FIG. 9b

FIG. 9c

Fig. 10

Fig. 11

Consistency in coherence

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2011060538 A1

**Non-patent literature cited in the description**

- *Intelligence and Security Informatics (ISI),* July 2007, 242-247
- *Journal of Power Sources,* January 2003, vol. 113, 72-80